# EUROPEAN PATENT APPLICATION

(11) **EP 3 076 425 A1**
(43) Date of publication of application: **05.10.2016**
(21) Application number: 13881450.4
(22) Date of filing: 27.11.2013
(51) Int. Cl.: H01L 21/336, H01L 29/78

(54) **SEMICONDUCTOR DEVICE**

(71) Applicant: Renesas Electronics Corporation, Tokyo 135-0061 (JP)
(72) Inventor: MORI, Takahiro, Kawasaki-shi Kanagawa 211-8668 (JP)
(74) Representative: Addiss, John William
(86) International application number: PCT/JP2013/081838
(87) International publication number: WO 2015/079511

(57) **Abstract**

A semiconductor substrate (SUB) has a recessed portion (CP1) and a recessed portion (CP2) in a main surface. An n⁺ source region (SR) and an n⁺ drain region (DR) sandwich the recessed portion (CP1) and the recessed portion (CP2) in the main surface. A p⁻ epitaxial region (EP) and a p-type well region (WL) serving as a channel formation region are formed in the main surface between the n⁺ source region (SR) and the recessed portion (CP1). A gate electrode layer (GE) is formed on the channel region with a gate insulation film (GI) interposed therebetween, and extends onto an element isolation insulation film (SI) in the recessed portion (CP1). The recessed portion (CP1) and the recessed portion (CP2) are arranged to be adjacent to each other to sandwich a substrate protruding portion (CV) protruding toward the main surface side with respect to a bottom portion of each of the recessed portion (CP1) and the recessed portion (CP2).

## Description

### TECHNICAL FIELD

The present invention relates to a semiconductor device, and for example, a semiconductor device having a lateral element.

### BACKGROUND ART

A lateral high-breakdown-voltage MOS (Lateral Diffused Metal Oxide Semiconductor: LDMOS) transistor is disclosed in, for example, Japanese Patent Laying-Open No. 2011-3608 (PTD 1).

In the semiconductor device described in this document, a p⁺ buried region is formed between an n⁺ buried region and a p⁻ epitaxial region. This p⁺ buried region has a p-type impurity concentration higher than that of the p⁻ epitaxial region. As a result, occurrence of punch-through is suppressed and the breakdown voltage is maintained high.

In addition, in the semiconductor device described in the aforementioned document, the p⁻ epitaxial region has a p-type impurity concentration lower than that of a p-type body region. As a result, in a breakdown state, a depletion layer extends toward the p⁻ epitaxial region side from a pn junction between an n-type drift region and the p⁻ epitaxial region, which allows high breakdown voltage.

### CITATION LIST

### PATENT DOCUMENT

PTD 1: Japanese Patent Laying-Open No. 2011-3608

### SUMMARY OF INVENTION

### TECHNICAL PROBLEM

According to the semiconductor device described in the aforementioned document, the breakdown voltage can be improved in the LDMOS transistor. There is, however, a room for further improvement to provide a semiconductor device having more excellent element characteristics.

The other problems and novel features will become apparent from the description of the specification and the accompanying drawings.

### SOLUTION TO PROBLEM

In a semiconductor device according to one embodiment, a semiconductor substrate has a main surface and has a first recessed portion and a second recessed portion in the main surface. An element isolation insulation film is formed inside each of the first recessed portion and the second recessed portion. A pair of impurity regions are formed to sandwich the first recessed portion and the second recessed portion in the main surface and serve as any one of a pair of source/drain regions and a pair of emitter/collector regions. One region of the pair of impurity regions has a first conductivity type. A first region of a second conductivity type is formed in the main surface between the one region and the first recessed portion and serves as a channel formation region. A gate electrode layer is formed on the first region with a gate insulation film interposed therebetween, and extends at least onto the element isolation insulation film in the first recessed portion. The first recessed portion and the second recessed portion are arranged to be adjacent to each other to sandwich a substrate protruding portion protruding toward the main surface side with respect to a bottom portion of each of the first recessed portion and the second recessed portion.

### ADVANTAGEOUS EFFECTS OF INVENTION

According to the semiconductor device in one embodiment, a semiconductor device having more excellent element characteristics can be realized.

### BRIEF DESCRIPTION OF DRAWINGS

Fig. 1 is a plan view schematically showing a configuration of a semiconductor device according to a first embodiment.
Fig. 2 is a cross-sectional view schematically showing a configuration taken along line II-II in Fig. 1.
Fig. 3 is a cross-sectional view schematically showing a configuration of a semiconductor device according to a comparative example.
Fig. 4 is a view showing a change in ON breakdown voltage when a gate overlap amount GF is changed in each of the configurations shown in Figs. 2 and 3.
Fig. 5 is a view showing a change in ON resistance when gate overlap amount GF is changed in each of the configurations shown in Figs. 2 and 3.
Fig. 6 is a view showing a change in OFF breakdown voltage when gate overlap amount GF is changed in each of the configurations shown in Figs. 2 and 3.
Fig. 7 is a view showing a potential during the ON operation in the configuration shown in Fig. 3.
Fig. 8 is a view showing a potential during the ON operation in the configuration shown in Fig. 2.
Fig. 9 is a plan view schematically showing a modification of the configuration of the semiconductor device according to the first embodiment.
Fig. 10 is a plan view schematically showing another modification of the configuration of the semiconductor device according to the first embodiment.
Fig. 11 is a plan view schematically showing still another modification of the configuration of the semiconductor device according to the first embodiment.
Fig. 12 is a cross-sectional view schematically showing a configuration of a semiconductor device according to a second embodiment.
Fig. 13 is a cross-sectional view schematically showing a modification of the configuration of the semiconductor device according to the second embodiment.
Fig. 14 is a view showing a change in ON breakdown voltage when gate overlap amount GF is changed in each of the configurations shown in Figs. 2, 3, 12, and 13.
Fig. 15 is a view showing a change in ON resistance when gate overlap amount GF is changed in each of the configurations shown in Figs. 2, 3, 12, and 13.
Fig. 16 is a view showing a change in OFF breakdown voltage when gate overlap amount GF is changed in each of the configurations shown in Figs. 2, 3, 12, and 13.
Fig. 17 is a view showing a potential during the ON operation in the configuration shown in Fig. 12.
Fig. 18 is a plan view schematically showing a planar shape of the configuration shown in Fig. 12.
Fig. 19 is a plan view schematically showing a modification of the planar shape of the configuration shown in Fig. 12.
Fig. 20 is a plan view schematically showing another modification of the planar shape of the configuration shown in Fig. 12.
Fig. 21 is a plan view schematically showing still another modification of the planar shape of the configuration shown in Fig. 12.
Fig. 22 is a plan view schematically showing a further modification of the planar shape of the configuration shown in Fig. 12.
Fig. 23 is a plan view schematically showing a planar shape of a configuration in which both a p-type region and an n-type region are present in an active region between element isolation insulation films.
Fig. 24 is a plan view schematically showing a modification of the planar shape of the configuration in which both the p-type region and the n-type region are present in the active region between the element isolation insulation films.
Fig. 25 is a plan view schematically showing another modification of the planar shape of the configuration in which both the p-type region and the n-type region are present in the active region between the element isolation insulation films.
Fig. 26 is a plan view schematically showing still another modification of the planar shape of the configuration in which both the p-type region and the n-type region are present in the active region between the element isolation insulation films.
Fig. 27 is a cross-sectional view schematically showing a configuration of a semiconductor device according to a third embodiment.
Fig. 28 is a cross-sectional view schematically showing a modification of the configuration of the semiconductor device according to the third embodiment.
Fig. 29 is a plan view schematically showing a planar shape of the configuration shown in Fig. 27.
Fig. 30 is a plan view schematically showing a modification of the planar shape of the configuration shown in Fig. 27.
Fig. 31 is a plan view schematically showing another modification of the planar shape of the configuration shown in Fig. 27.
Fig. 32 is a plan view schematically showing still another modification of the planar shape of the configuration shown in Fig. 27.
Fig. 33 is a plan view schematically showing a further modification of the planar shape of the configuration shown in Fig. 27.
Fig. 34 is a cross-sectional view schematically showing a configuration of a semiconductor device according to a fourth embodiment.
Fig. 35 is a cross-sectional view schematically showing a configuration in which the configuration according to the first embodiment is applied to an IGBT.
Fig. 36 is a cross-sectional view schematically showing a configuration in which the configuration according to the first embodiment is applied to a bidirectional transistor.
Fig. 37 is a cross-sectional view schematically showing a configuration in which the configuration according to the first embodiment is applied to a LOCOS.
Fig. 38 is a cross-sectional view schematically showing a configuration in which an element isolation insulation film is formed on a substrate protruding portion in the configuration according to the first embodiment.
Fig. 39 is a view showing a change in ON breakdown voltage when a depth D of a recessed portion CP4 is changed in the configuration according to the present modification shown in Fig. 38.
Fig. 40 is a view showing a change in ON resistance when depth D of recessed portion CP4 is changed in the configuration according to the present modification shown in Fig. 38.
Fig. 41 is a view showing a change in OFF breakdown voltage when depth D of recessed portion CP4 is changed in the configuration according to the present modification shown in Fig. 38.

### DESCRIPTION OF EMBODIMENTS

Embodiments will be described hereinafter with reference to the drawings.

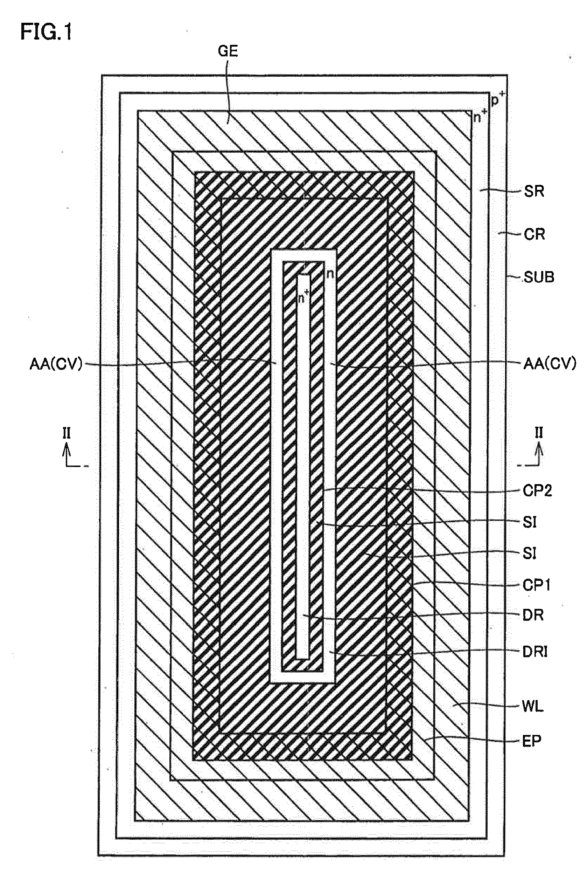

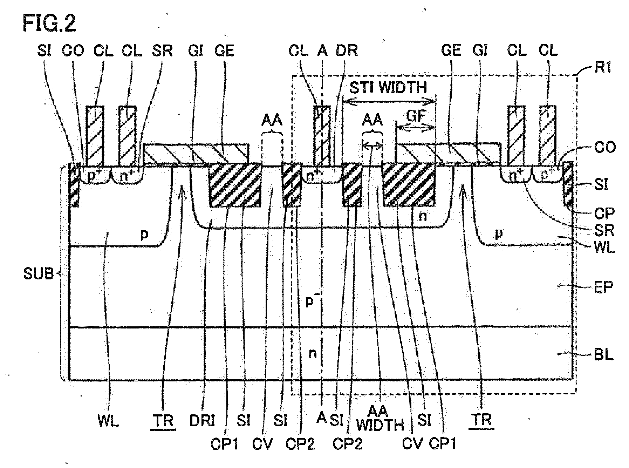

Referring to Figs. 1 and 2, a semiconductor device according to the present embodiment has, for example, an LDMOS transistor TR. This semiconductor device mainly has a semiconductor substrate SUB, an n-type buried layer BL, a p⁻ epitaxial region EP, an n-type drift region DRI, a p-type well region WL, an n⁺ source region SR (one region of a pair of impurity regions), an n⁺ drain region DR (the other region of the pair of impurity regions), a p⁺ contact region CO, a gate insulation film GI, a gate electrode layer GE, an element isolation structure, and a conductive layer CL.

Referring mainly to Fig. 2, semiconductor substrate SUB is made of, for example, silicon. This semiconductor substrate SUB has a main surface (surface on the upper side in the figure). N-type buried layer BL is formed inside this semiconductor substrate SUB. Inside semiconductor substrate SUB and on the main surface side of n-type buried layer BL, p⁻ epitaxial region EP is formed to make a pn junction with n-type buried layer BL.

Inside semiconductor substrate SUB and on the main surface side of p⁻ epitaxial region EP, n-type drift region DRI and p-type well region WL are formed. This n-type drift region DRI makes a pn junction with p⁻ epitaxial region EP, which extends in the direction along the main surface. P-type well region WL is formed to be in contact with p⁻ epitaxial region EP, and has a p-type impurity concentration higher than that of p⁻ epitaxial region EP.

The element isolation structure has, for example, an STI (Shallow Trench Isolation) structure. This element isolation structure having the STI structure has recessed portions CP1, CP2 and CP, and an element isolation insulation film SI. Each of recessed portions CP1, CP2 and CP is formed in the main surface of semiconductor substrate SUB. Element isolation insulation film SI is formed to fill in each of recessed portions CP1, CP2 and CP.

Recessed portion CP1 (first recessed portion) and recessed portion CP2 (second recessed portion) are formed in the main surface inside n-type drift region DRI, and are formed to be shallower than n-type drift region DRI.

N⁺ drain region DR is formed in the main surface of semiconductor substrate SUB to be in contact with n-type drift region DRI, and has an n-type impurity concentration higher than that of n-type drift region DRI. N⁺ source region SR is formed in the main surface of semiconductor substrate SUB inside p-type well region WL to make a pn junction with p-type well region WL.

In the main surface of semiconductor substrate SUB, n⁺ drain region DR and n⁺ source region SR are arranged to sandwich recessed portion CP1 and recessed portion CP2. In the main surface of semiconductor substrate SUB, n⁺ drain region DR is in contact with recessed portion CP2.

In the main surface of semiconductor substrate SUB, p-type well region WL and p⁻ epitaxial region EP are arranged between n⁺ source region SR and recessed portion CP1. A portion located in the main surface of semiconductor substrate SUB, of p-type well region WL and p⁻ epitaxial region EP sandwiched between n⁺ source region SR and recessed portion CP 1, is a portion serving as a channel formation region (first region). In the main surface of semiconductor substrate SUB, p⁺ contact region CO is formed to be adjacent to n⁺ source region SR.

Gate electrode layer GE is formed on the channel formation region (p-type well region WL and p⁻ epitaxial region EP) sandwiched between n⁺ source region SR and recessed portion CP1, with gate insulation film GI interposed between gate electrode layer GE and the channel formation region. A part of this gate electrode layer GE is also located on a part of n-type drift region DRI with gate insulation film GI interposed therebetween, and extends over element isolation insulation film SI for filling in recessed portion CP1.

Conductive layer CL serving as a drain electrode is formed on the main surface of semiconductor substrate SUB so as to be electrically connected to n⁺ drain region DR. Conductive layer CL serving as a source electrode is formed on the main surface of semiconductor substrate SUB so as to be electrically connected to n⁺ source region SR. In addition, conductive layer CL is formed on the main surface of semiconductor substrate SUB so as to be electrically connected to p⁺ contact region CO.

In the aforementioned configuration, in the main surface of semiconductor substrate SUB, recessed portion CP1 and recessed portion CP2 are arranged to be adjacent to each other to sandwich a substrate protruding portion CV protruding toward the main surface side (the upper side in the figure) with respect to a bottom portion of each of recessed portion CP1 and recessed portion CP2. Element isolation insulation film SI is not formed on this substrate protruding portion CV and a main surface of substrate protruding portion CV serves as an active region AA. Namely, recessed portion CP1 and recessed portion CP2 are isolated from each other in the main surface by substrate protruding portion CV serving as active region AA.

In the present embodiment, n-type drift region DRI is formed in a main surface of this active region AA. Therefore, the main surface of active region AA has an n-type impurity concentration lower than an n-type impurity concentration of the main surface of n⁺ source region SR. In addition, in the present embodiment, gate electrode layer GE does not extend onto active region AA.

The n-type impurity concentration of the n-type drift region is, for example, 1×10¹⁶ cm⁻³, and the n-type impurity concentration of each of n⁺ source region SR and n⁺ drain region DR is, for example, 1×10¹⁸ cm⁻³.

In the cross section shown in Fig. 2, LDMOS transistor TR is formed to have a configuration that is line-symmetric with respect to an imaginary line A-A passing through n⁺ drain region DR.

Referring mainly to Fig. 1, recessed portion CP2 is formed as a trench surrounding the entire perimeter of n⁺ drain region DR formed in the main surface of semiconductor substrate SUB in a planar view. Therefore, element isolation insulation film SI for filling in recessed portion CP2 is also formed to surround the entire perimeter of n⁺ drain region DR in a planar view. Substrate protruding portion CV (active region AA) is formed to surround the entire outer perimeter of recessed portion CP2 in a planar view.

In addition, recessed portion CP1 is formed as a trench surrounding the entire outer perimeter of recessed portion CP2, with substrate protruding portion CV (active region AA) interposed therebetween, in a planar view. Therefore, element isolation insulation film SI for filling in recessed portion CP1 is also formed to surround the entire outer perimeter of recessed portion CP2, with substrate protruding portion CV (active region AA) interposed therebetween, in a planar view.

Gate electrode layer GE is formed to overlap with a part of the outer perimeter portion of element isolation insulation film SI for filling in recessed portion CP1 and surround the entire outer perimeter of element isolation insulation film SI for filling in recessed portion CP1 in a planar view. In addition, n⁺ source region SR is formed to surround the entire outer perimeter of gate electrode layer GE in a planar view, and p⁺ contact region CO is formed to surround the entire outer perimeter of n⁺ source region SR in a planar view. In addition, in a planar view, p-type well region WL surrounds the perimeter of n-type drift region DRI with a part of p⁻ epitaxial region EP interposed therebetween in the main surface.

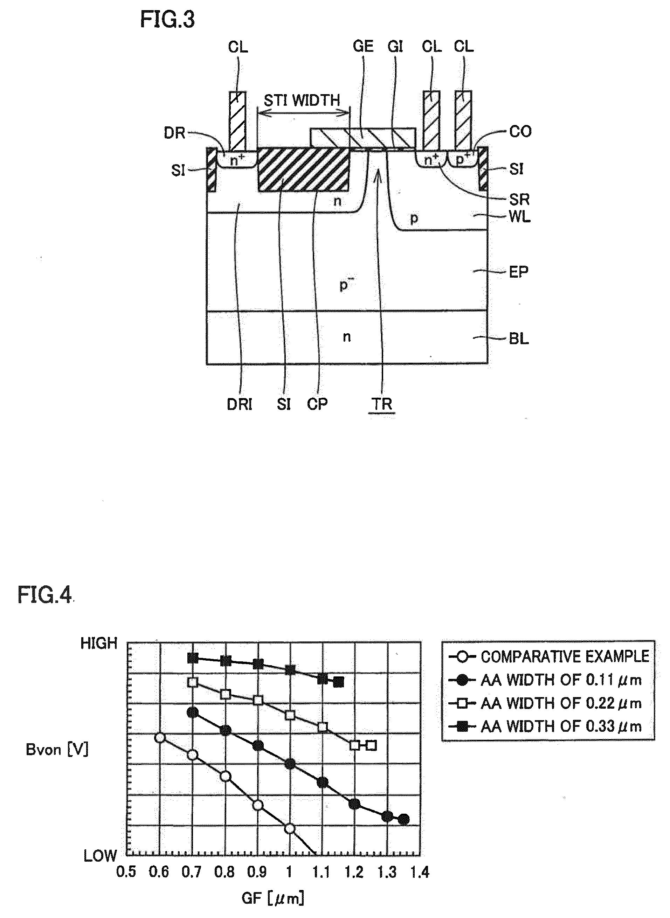

Next, results of study on an ON breakdown voltage (Bvon), an ON resistance (Rsp) and an OFF breakdown voltage (Bvoff) of the semiconductor device according to the present embodiment will be described with reference to Figs. 4 to 6, in comparison with a comparative example shown in Fig. 3.

Fig. 3 is a cross-sectional view showing a configuration of a semiconductor device according to the comparative example and this cross-sectional view is a view showing a portion corresponding to a region R1 shown in Fig. 2. Referring to Fig. 3, in the semiconductor device according to the comparative example, recessed portion CP located between n⁺ source region SR and n⁺ drain region DR is not isolated by the active region. The other configuration according to the comparative example is substantially the same as the configuration according to the present embodiment shown in Fig. 2, and thus, the same reference characters are assigned to the same components and description thereof will not be repeated.

Figs. 4 to 6 are views of the simulation results showing changes in ON breakdown voltage (Bvon), ON resistance (Rsp) and OFF breakdown voltage (Bvoff) when a dimension GF (gate overlap amount: Fig. 2) of overlap in a planar view between gate electrode layer GE and element isolation insulation film SI for filling in recessed portion CP1 (Fig. 2) or recessed portion CP (Fig. 3) is changed, respectively. This simulation was performed under the condition that each of an STI width in the present embodiment (Fig. 2) and an STI width in the comparative example (Fig. 3) was 1.7 µm.

Referring to Fig. 4, it was found that the ON breakdown voltage can be further improved in the present embodiment (black squares, white squares and black circles in the figure) than in the comparative example (white circles in the figure). It was also found that in the present embodiment, the ON breakdown voltage can be improved as a dimension (AA width: Fig. 2) between recessed portion CP1 and recessed portion CP2 becomes larger.

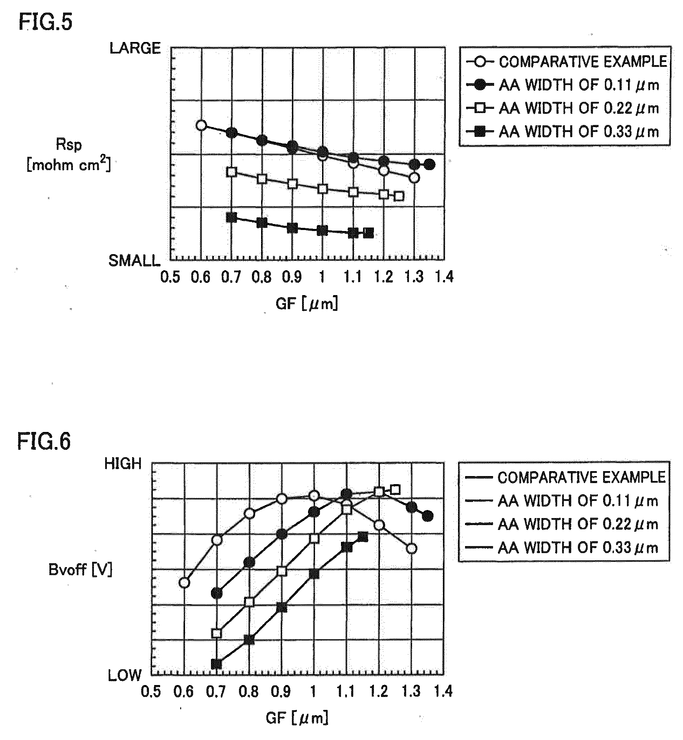

Referring to Fig. 5, it was found that the ON resistance can be further reduced in the present embodiment (black squares, white squares and black circles in the figure) than in the comparative example (white circles in the figure). It was also found that in the present embodiment, the ON resistance can be reduced as the dimension (AA width: Fig. 2) between recessed portion CP1 and recessed portion CP2 becomes larger.

Referring to Fig. 6, it was found that the OFF breakdown voltage can be further improved in the present embodiment (black squares, white squares and black circles in the figure) than in the comparative example (white circles in the figure), as gate overlap amount GF described above becomes larger. Therefore, as to the OFF breakdown voltage, it was found that, by adjusting gate overlap amount GF, the OFF breakdown voltage equal to or higher than that in the comparative example is obtained in the present embodiment as well.

Next, a reason why the results of the ON breakdown voltage (Bvon), the ON resistance (Rsp) and the OFF breakdown voltage (Bvoff) shown in Figs. 4 to 6 were obtained will be discussed with reference to Figs. 2, 3, 7, and 8.

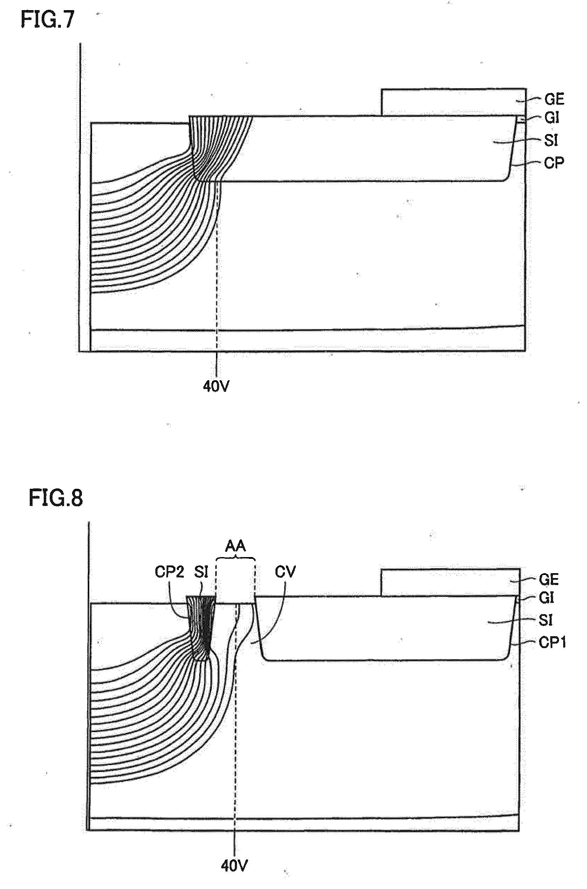

It is conceivable that the ON breakdown voltage was further improved in the present embodiment shown in Fig. 2 than in the comparative example shown in Fig. 3 because substrate protruding portion CV (active region AA) is present between recessed portion CP1 and recessed portion CP2 and thus a depletion layer does not easily extend from the n⁺ source region SR side to the n⁺ drain region DR side. This can also be seen from comparison between potentials in Figs. 7 and 8. It should be noted that a plurality of curved lines shown in Figs. 7 and 8 are contour lines of the potential in the depletion layer.

Specifically, in the present embodiment shown in Fig. 8, substrate protruding portion CV (active region AA) is present between recessed portion CP1 and recessed portion CP2, and thus, the contour lines of the potential enter this substrate protruding portion CV (active region AA) as well. As a result, as compared with the comparative example shown in Fig. 7, the contour lines of the potential are located closer to the n⁺ drain region DR side in the present embodiment shown in Fig. 8. Therefore, as compared with the comparative example shown in Fig. 7, a broken line indicating the potential of 40 V in the figure is located closer to the n⁺ drain region DR side and an electric field is relaxed by substrate protruding portion CV (active region AA) between recessed portion CP1 and recessed portion CP2 in the present embodiment shown in Fig. 8. As described above, the improvement of the ON breakdown voltage is considered to be caused by the relaxation of the electric field by substrate protruding portion CV (active region AA).

In addition, it is conceivable that the ON resistance was reduced because substrate protruding portion CV (active region AA) is provided between recessed portion CP1 and recessed portion CP2 as in the present embodiment shown in Fig. 2, and thus, a current-flowing region increases by a width of substrate protruding portion CV (active region AA).

In addition, it is conceivable that the OFF breakdown voltage was further reduced in the present embodiment shown in Fig. 2 than in the comparative example shown in Fig. 3 because substrate protruding portion CV (active region AA) is present between recessed portion CP1 and recessed portion CP2. Here, when gate overlap amount GF is increased in the comparative example, the electric field concentrates on an end of recessed portion CP on the n⁺ drain region DR side in Fig. 3, which is considered to reduce the OFF breakdown voltage. In contrast, when gate overlap amount GF is increased in the present embodiment, the electric field is relaxed by substrate protruding portion CV (active region AA) between recessed portion CP1 and recessed portion CP2 in Fig. 2, which is considered to improve the OFF breakdown voltage.

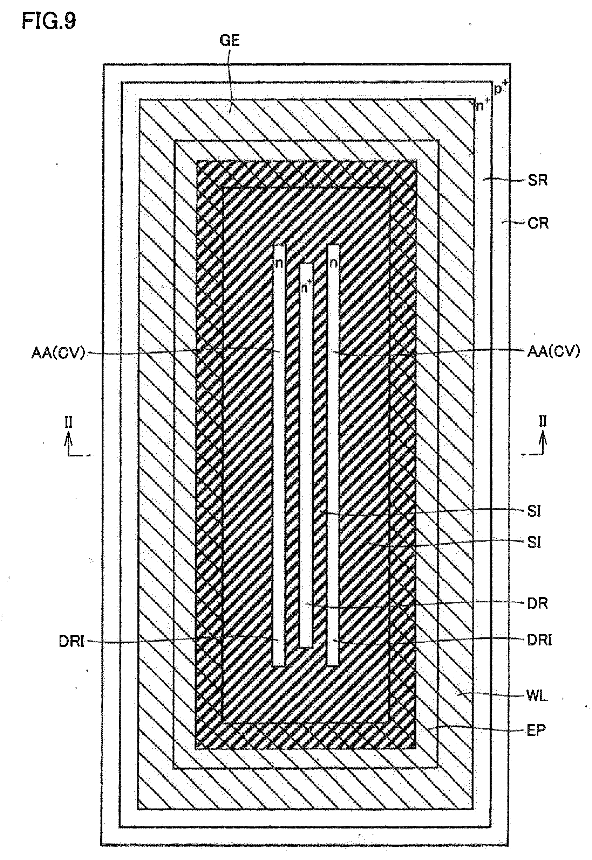

Next, a modification of a planar structure of the present embodiment in a planar view will be described with reference to Figs. 9 to 11.

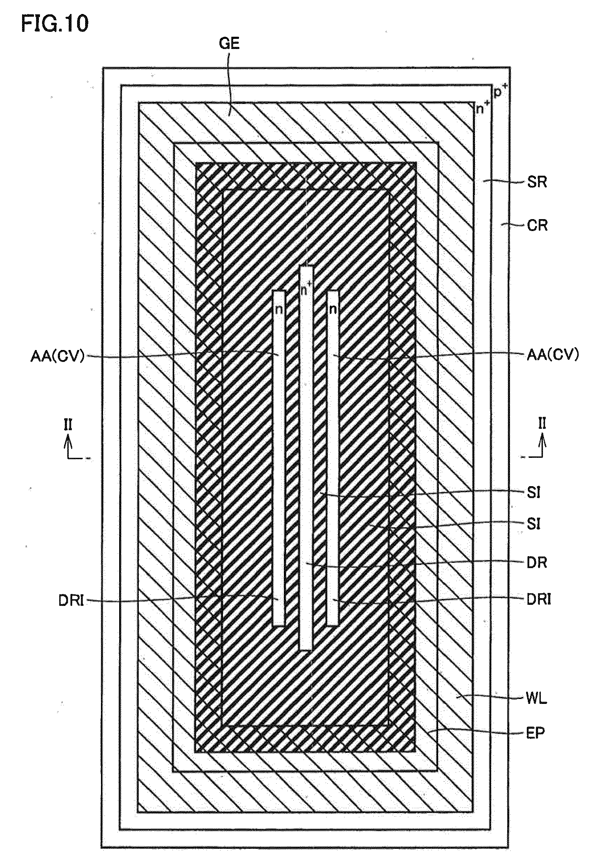

With reference to Fig. 1, such a configuration has been described that substrate protruding portion CV (active region AA) having n-type drift region DRI formed in a surface thereof surrounds the entire perimeter of n⁺ drain region DR in a planar view (e.g., a rectangular frame shape in a planar view). However, as shown in Figs. 9 and 10, substrate protruding portion CV (active region AA) does not necessarily need to surround the perimeter of n⁺ drain region DR in a planar view.

In the configuration shown in Figs. 9 and 10, substrate protruding portion CV (active region AA) may have a straight line shape extending to run in the same direction (vertical direction in the figure) as the longitudinal direction of n⁺ drain region DR in a planar view. In a planar view, a length in the longitudinal direction (vertical direction in the figure) of substrate protruding portion CV (active region AA) having the straight line shape may be longer than a length in the longitudinal direction of n⁺ drain region DR, or may be shorter than a length in the longitudinal direction of n⁺ drain region DR as shown in Fig. 10.

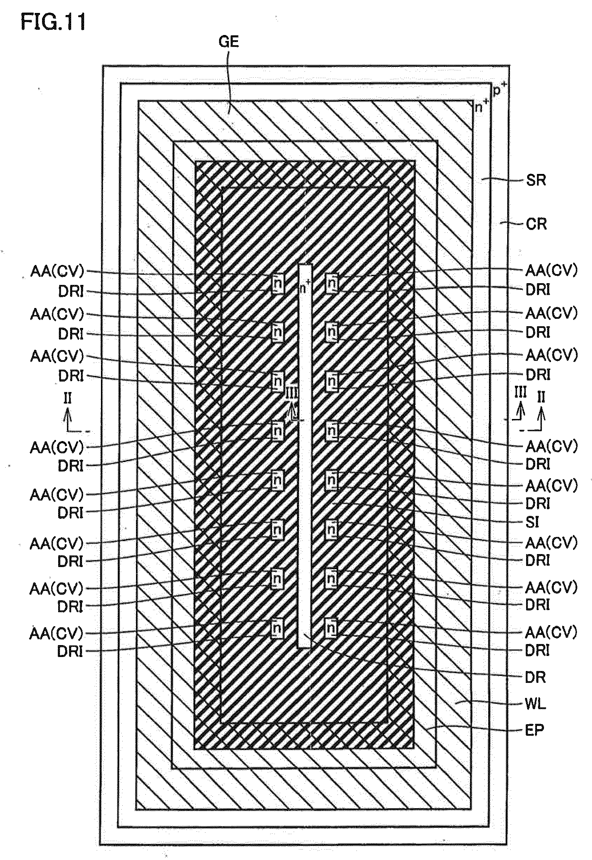

As shown in Fig. 11, a plurality of substrate protruding portions CV (active regions AA) may be arranged intermittently along the same direction (vertical direction in the figure) as the longitudinal direction of n⁺ drain region DR in a planar view. Namely, element isolation insulation film SI is located between the plurality of substrate protruding portions CV (active regions AA) arranged along the longitudinal direction of n⁺ drain region DR.

A cross section taken along line II-II in each of Figs. 9 to 11 corresponds to the configuration shown in Fig. 2. In addition, a cross section taken along line III-III in Fig. 11 corresponds to the configuration shown in Fig. 3.

In the present embodiment, as shown in Fig. 2, substrate protruding portion CV (active region AA) is arranged between recessed portion CP1 and recessed portion CP2 in the main surface of semiconductor substrate SUB. Therefore, as shown in Figs. 4 and 5, it is possible to improve the ON breakdown voltage and reduce the ON resistance as compared with those in the comparative example (Fig. 3). In addition, as shown in Fig. 6, as to the OFF breakdown voltage, by adjusting gate overlap amount GF, the OFF breakdown voltage equal to or higher than that in the comparative example (Fig. 3) can be obtained in the present embodiment as well.

### (Second Embodiment)

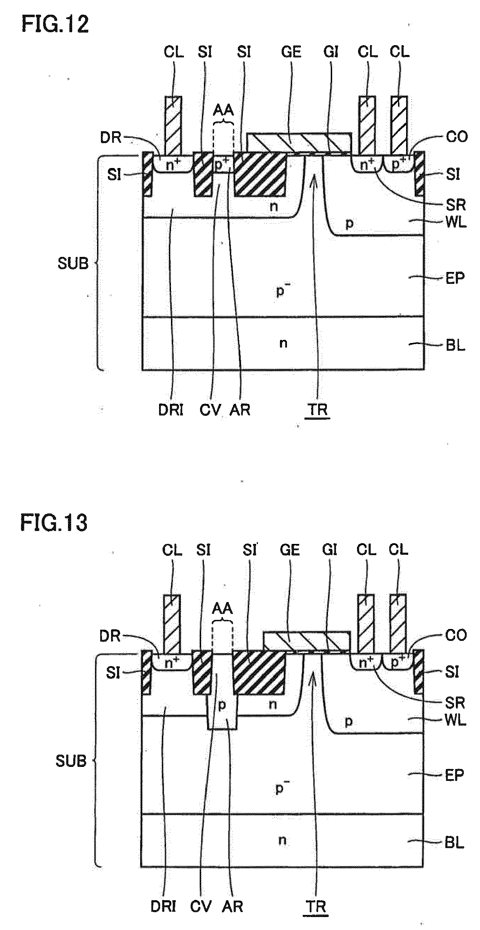

Referring to Fig. 12, a configuration according to the present embodiment is different from the configuration according to the first embodiment shown in Fig. 2 in that a p-type impurity region AR (second region) is formed in the surface (main surface) of substrate protruding portion CV (active region AA) between recessed portion CP1 and recessed portion CP2. This p-type impurity region AR is formed to be shallower than the depth position of the bottom surface of each of recessed portions CP1 and CP2. P-type impurity region AR has the same impurity concentration as that of p⁺ contact region CO and may be formed in the same step as the step of forming p⁺ contact region CO.

A potential of p-type impurity region AR is fixed to a floating (floating potential) or GND (ground potential) level. As a method for fixing the potential of p-type impurity region AR to the GND level, a conductive layer (not shown) can be connected to p-type impurity region AR from above the main surface of semiconductor substrate SUB and the GND level can be applied to p-type impurity region AR through this conductive layer.

As another method for fixing the potential of p-type impurity region AR to the GND level, p-type impurity region AR may be formed to reach p⁻ epitaxial region EP as shown in Fig. 13. In this case, p-type impurity region AR is formed to be deeper than the depth position of the bottom surface of each of recessed portions CP1 and CP2. P-type impurity region AR has the same impurity concentration as that of p-type well region WL and may be formed in the same step as the step of forming p-type well region WL.

The configuration other than described above, of the configuration according to the present embodiment shown in each of Figs. 12 and 13, is substantially the same as the configuration according to the first embodiment, and thus, the same reference characters are assigned to the same components and description thereof will not be repeated.

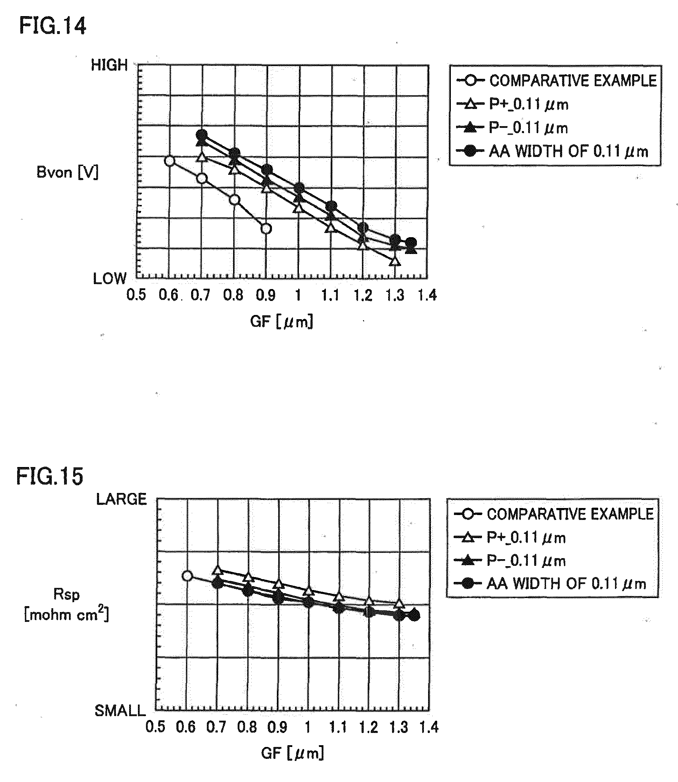

Next, results of study on the ON breakdown voltage (Bvon), the ON resistance (Rsp) and the OFF breakdown voltage (Bvoff) of the semiconductor device according to the present embodiment will be described with reference to Figs. 14 to 16, in comparison with the comparative example shown in Fig. 3 and the configuration according to the first embodiment shown in Fig. 2.

Figs. 14 to 16 are views of the simulation results showing changes in ON breakdown voltage (Bvon), ON resistance (Rsp) and OFF breakdown voltage (Bvoff) when dimension GF (gate overlap amount: Fig. 2) of overlap in a planar view between gate electrode layer GE and element isolation insulation film SI for filling in recessed portion CP1 is changed, respectively. This simulation was performed under the conditions that each of an STI width in the present embodiment (similar to the STI width shown in Fig. 2) and the STI width in the comparative example (Fig. 3) was 1.7 µm, and the AA width in each of the first embodiment and the present embodiment was 0.11 µm.

Referring to Fig. 14, the result in the configuration according to the present embodiment shown in Fig. 12 is indicated by white triangles in the figure, and the result in the configuration according to the present embodiment shown in Fig. 13 is indicated by black triangles in the figure. It was found that the ON breakdown voltage can be further improved in the present embodiment (white triangles and black triangles in the figure) than in the comparative example shown in Fig. 3 (white circles in the figure). It was also found that the ON breakdown voltage can be further improved in the configuration according to the present embodiment shown in Fig. 13 than in the configuration according to the present embodiment shown in Fig. 12.

Referring to Fig. 15, it was found that the ON resistance that is substantially equal to that in the comparative example shown in Fig. 3 (white circles in the figure) and the first embodiment (black circles in the figure) is obtained in the present embodiment (white triangles and black triangles in the figure).

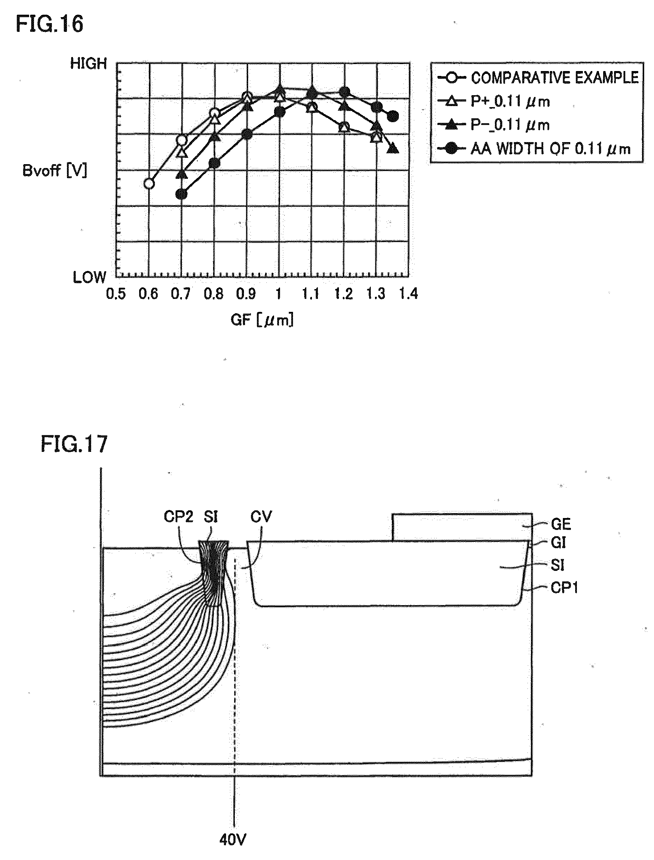

Referring to Fig. 16, it was found that the OFF breakdown voltage can be further improved in the configuration according to the present embodiment shown in Fig. 13 (black triangles in the figure) than in the comparative example shown in Fig. 3 (white circles in the figure), as gate overlap amount GF described above becomes larger. Therefore, as to the OFF breakdown voltage, it was found that, by adjusting gate overlap amount GF, the OFF breakdown voltage equal to or higher than that in the comparative example is obtained in the present embodiment as well.

It was also found that the OFF breakdown voltage that is substantially equal to that in the comparative example shown in Fig. 3 (white circles in the figure) is obtained in the configuration according to the present embodiment shown in Fig. 12 (white triangles in the figure). It was also found that, by adjusting gate overlap amount GF, the OFF breakdown voltage higher than that in the comparative example is obtained in the present embodiment as well.

Next, a reason why the results of the ON breakdown voltage (Bvon), the ON resistance (Rsp) and the OFF breakdown voltage (Bvoff) shown in Figs. 14 to 16 were obtained will be discussed with reference to Figs. 12, 13 and 17.

A reason why the ON breakdown voltage is improved in the configuration according to the present embodiment shown in each of Figs. 12 and 13 is the same as the reason described in the first embodiment. Specifically, it is conceivable that the ON breakdown voltage was further improved in the present embodiment shown in each of Figs. 12 and 13 than in the comparative example because substrate protruding portion CV (active region AA) is present between recessed portion CP1 and recessed portion CP2 and thus a depletion layer does not easily extend to the n⁺ drain region DR side. This can also be seen from a potential shown in Fig. 17.

Referring to Fig. 17, in the present embodiment, substrate protruding portion CV (active region AA) is present between recessed portion CP1 and recessed portion CP2, and thus, the contour lines of the potential enter this substrate protruding portion CV (active region AA) as well. As a result, as compared with the comparative example shown in Fig. 7, the contour lines of the potential are located closer to the n⁺ drain region DR side in the present embodiment shown in Fig. 17. Therefore, as compared with the comparative example shown in Fig. 7, a broken line indicating the potential of 40 V in the figure is located closer to the n⁺ drain region DR side and an electric field is relaxed by substrate protruding portion CV (active region AA) between recessed portion CP1 and recessed portion CP2 in the present embodiment shown in Fig. 17. The improvement of the ON breakdown voltage is considered to be caused by this relaxation of the electric field.

In addition, it is conceivable that the ON resistance was reduced because substrate protruding portion CV (active region AA) is provided between recessed portion CP1 and recessed portion CP2 as in the present embodiment shown in Figs. 12 and 13, and thus, a current-flowing region increases by a width of substrate protruding portion CV (active region AA), similarly to the first embodiment.

In addition, as to the OFF breakdown voltage, in the present embodiment shown in Figs. 12 and 13, a pn junction is made between n-type drift region DRI and p-type impurity region AR formed in the surface of substrate protruding portion CV (active region AA). Therefore, the electric field on the n⁺ drain region DR side is relaxed, and thus, it is considered to be possible to obtain the OFF breakdown voltage close to that in the comparative example shown in Fig. 3, without changing gate overlap amount GF.

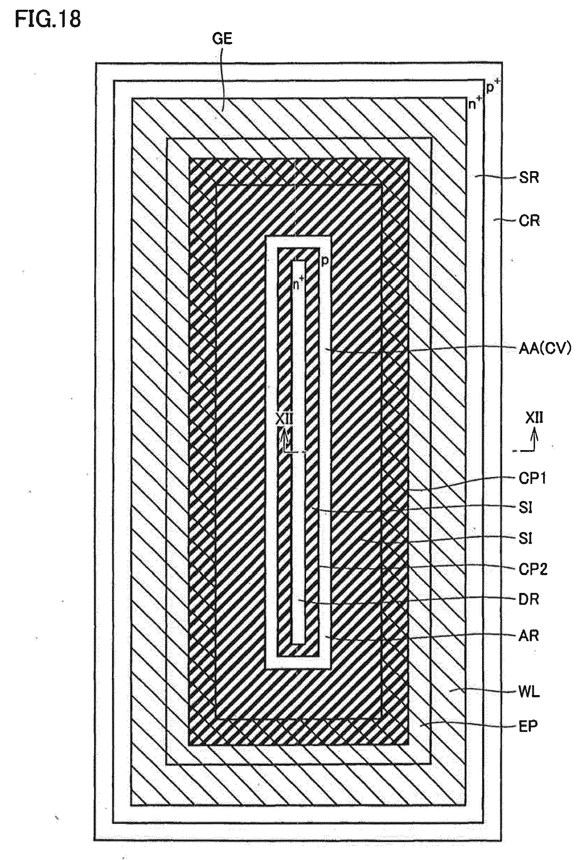

Next, a modification of a planar structure of the present embodiment in a planar view will be described with reference to Figs. 18 to 22.

Referring to Fig. 18, substrate protruding portion CV (active region AA) having p-type impurity region AR formed in the surface thereof may surround the entire perimeter of n⁺ drain region DR and recessed portion CP2 in a planar view. In this configuration, substrate protruding portion CV (active region AA) having p-type impurity region AR formed in the surface thereof has, for example, a rectangular frame shape in a planar view.

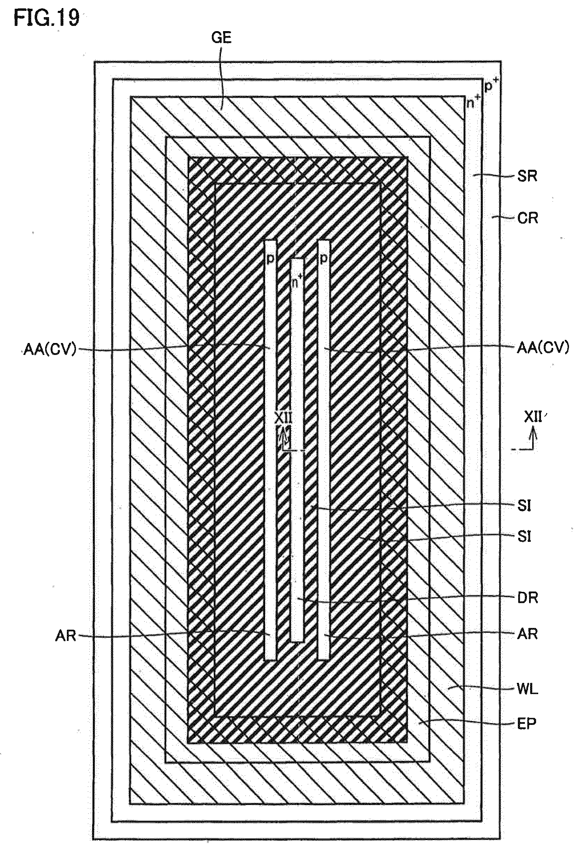

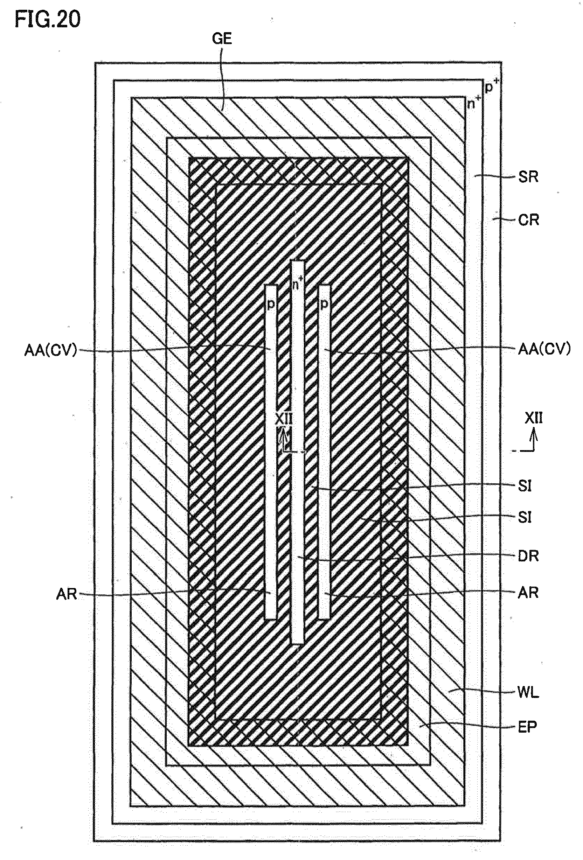

Referring to Figs. 19 and 20, substrate protruding portion CV (active region AA) does not necessarily need to surround the perimeter of n⁺ drain region DR in a planar view. In the configuration shown in Figs. 19 and 20, substrate protruding portion CV (active region AA) may have a straight line shape extending to run in the same direction (vertical direction in the figure) as the longitudinal direction of n⁺ drain region DR in a planar view. In a planar view, a length in the longitudinal direction (vertical direction in the figure) of substrate protruding portion CV (active region AA) having the straight line shape may be longer than a length in the longitudinal direction of n⁺ drain region DR as shown in Fig. 19, or may be shorter than a length in the longitudinal direction of n⁺ drain region DR as shown in Fig. 20.

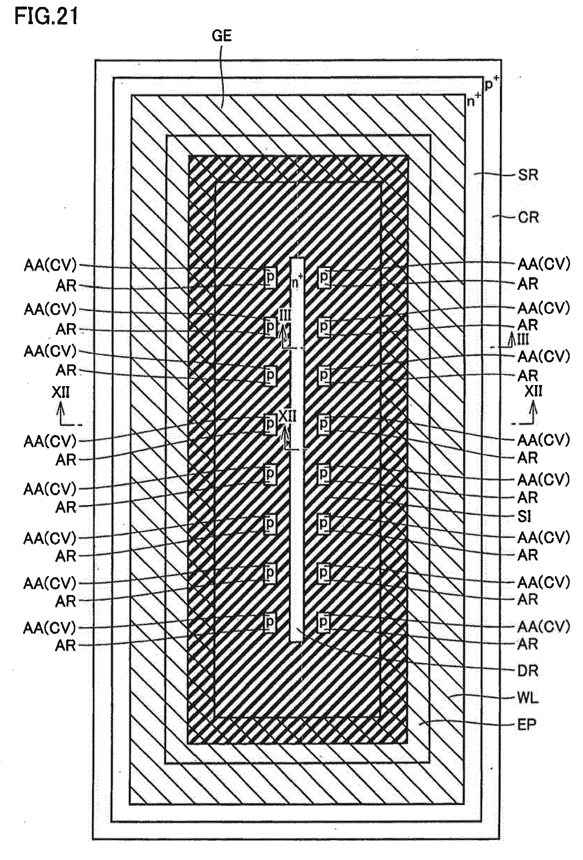

As shown in Fig. 21, a plurality of substrate protruding portions CV (active regions AA) may be arranged intermittently along the same direction (vertical direction in the figure) as the longitudinal direction of n⁺ drain region DR in a planar view. Namely, element isolation insulation film SI is located between the plurality of substrate protruding portions CV (active regions AA) arranged along the longitudinal direction of n⁺ drain region DR.

As shown in Figs. 18 to 21, gate electrode layer GE may surround the entire perimeter of drain region DR, substrate protruding portion CV (active region AA) and the like in a planar view. In this configuration, gate electrode layer GE has, for example, a rectangular frame shape in a planar view.

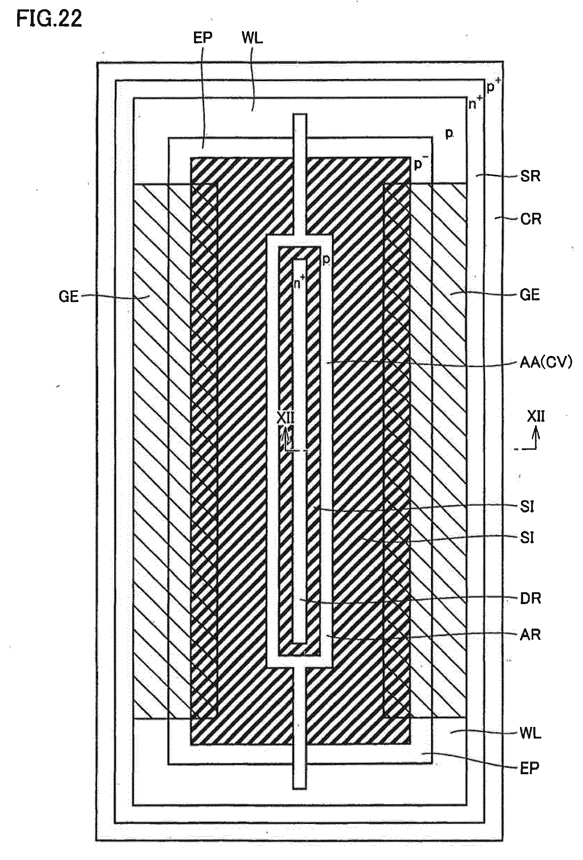

On the other hand, as shown in Fig. 22, gate electrode layer GE does not necessarily need to surround the entire perimeter of drain region DR, substrate protruding portion CV (active region AA) and the like in a planar view. In this configuration, gate electrode layer GE may be divided into two gate electrode portions each having a straight line shape formed to run along the same direction (vertical direction in the figure) as the longitudinal direction of n⁺ drain region DR in a planar view.

Substrate protruding portion CV (active region AA) having p-type impurity region AR formed in the surface thereof surrounds the entire perimeter of n⁺ drain region DR in a planar view and reaches p-type well region WL on the outer perimeter side. As a result, the potential of p-type impurity region AR can be fixed to the GND level.

A cross section taken along line XII-XII in each of Figs. 19 to 22 corresponds to the configuration shown in Fig. 12. In addition, a cross section taken along line III-III in Fig. 21 corresponds to the configuration shown in Fig. 3.

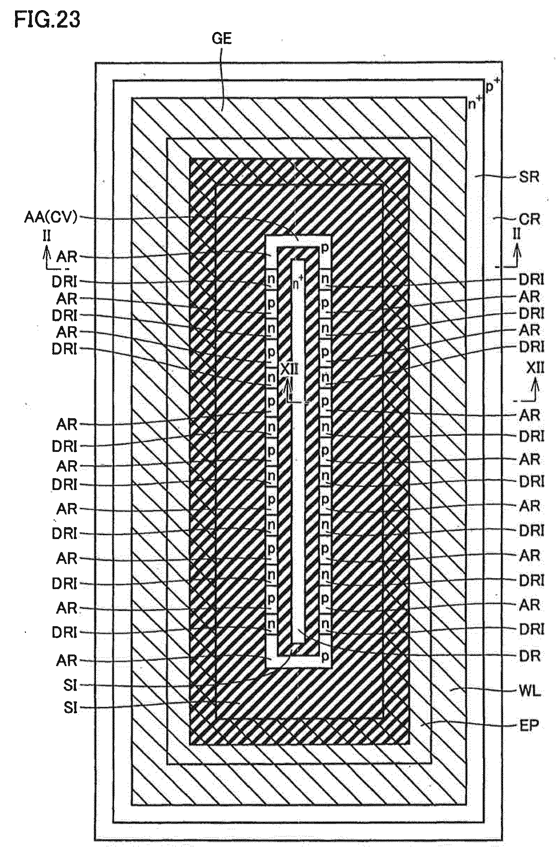

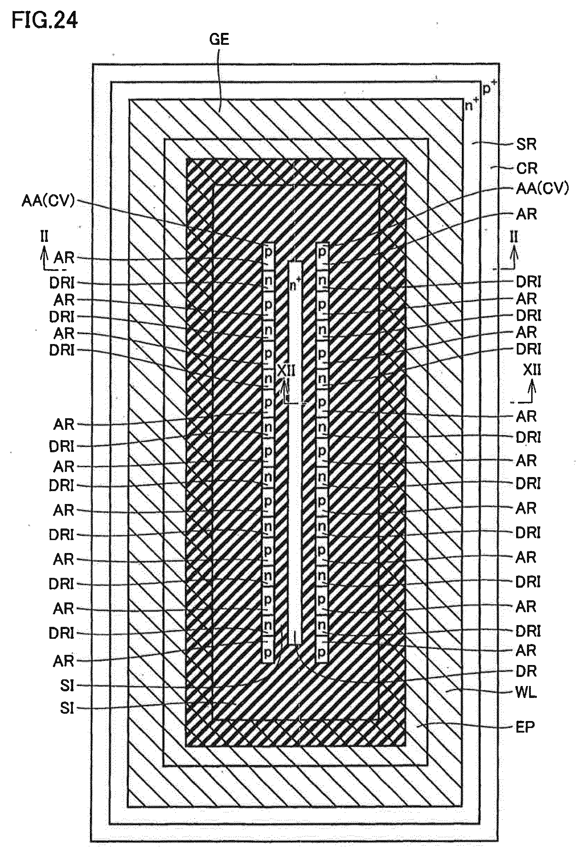

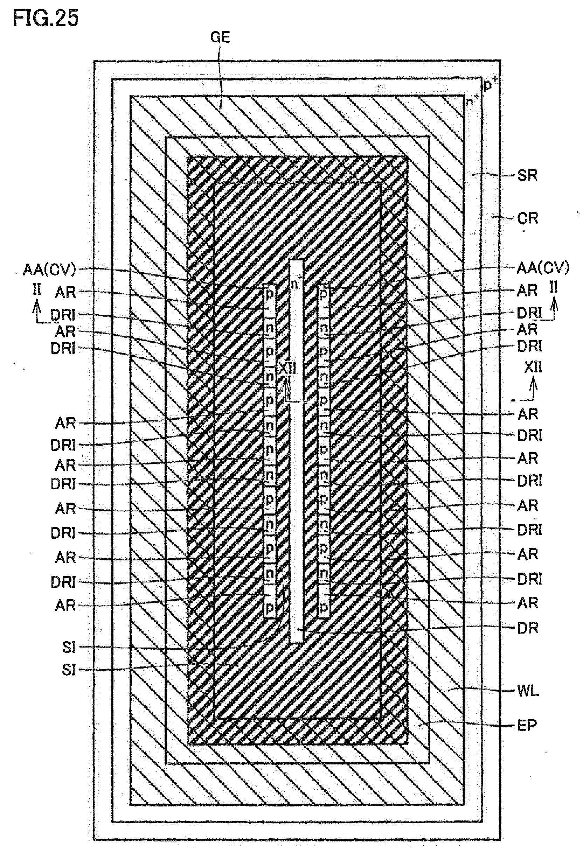

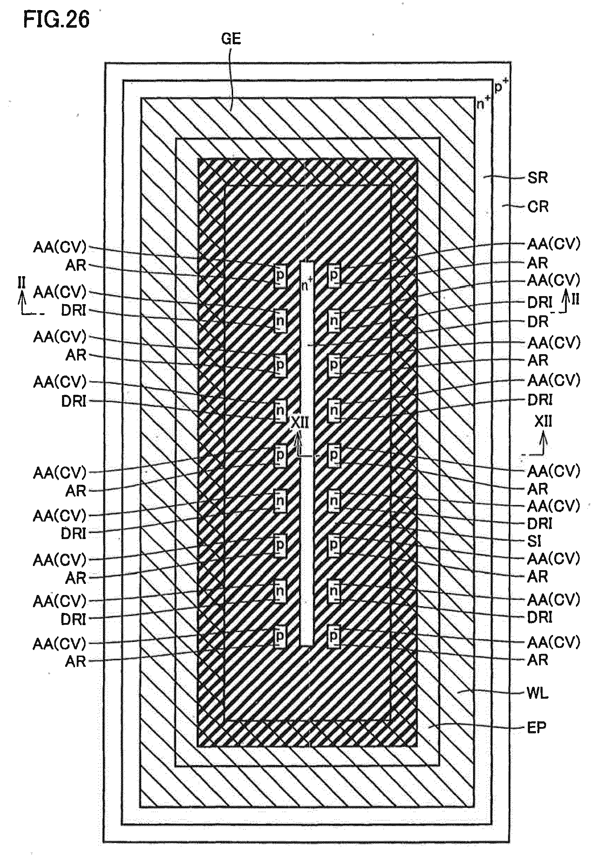

As shown in the plan views of Figs. 23 to 26, p-type impurity region AR (second region) and n-type drift region DRI (third region) may be present in the main surface of substrate protruding portion CV (active region AA). As shown in Fig. 23, p-type impurity regions AR and n-type drift regions DRI may be alternately arranged side by side along the longitudinal direction in the main surface of substrate protruding portion CV (active region AA) surrounding the entire perimeter of n⁺ drain region DR, in a planar view. As shown in Figs. 24 and 25, p-type impurity regions AR and n-type drift regions DRI may be alternately arranged side by side along the longitudinal direction in the main surface of substrate protruding portion CV (active region AA) having a straight line shape extending to run in the same direction (vertical direction in the figure) as the longitudinal direction of n⁺ drain region DR, in a planar view. Furthermore, as shown in Fig. 26, p-type impurity region AR and n-type drift region DRI may be alternately formed in the plurality of substrate protruding portions CV (active regions AA) arranged intermittently along the same direction (vertical direction in the figure) as the longitudinal direction of n⁺ drain region DR, in a planar view.

A cross section taken along line II-II in each of Figs. 23 to 26 corresponds to the configuration shown in Fig. 2, and a cross section taken along line XII-XII in each of Figs. 23 to 26 corresponds to the configuration shown in Fig. 12.

According to the present embodiment, as shown in Figs. 12 and 13, substrate protruding portion CV (active region AA) is arranged between recessed portion CP1 and recessed portion CP2 in the main surface of semiconductor substrate SUB. Therefore, as shown in Figs. 14 and 15, it is possible to reduce the ON resistance while maintaining the ON breakdown voltage, as compared with the comparative example (Fig. 3).

In addition, according to the present embodiment, as shown in Figs. 12 and 13, the pn junction is made between n-type drift region DRI and p-type impurity region AR formed in substrate protruding portion CV (active region AA). Therefore, the electric field on the drain side is relaxed, and thus, the OFF breakdown voltage that is substantially equal to that in the comparative example can be obtained without adjusting gate overlap amount GF. By adjusting gate overlap amount GF, the OFF breakdown voltage equal to or higher than that in the comparative example can be obtained in the present embodiment as well.

### (Third Embodiment)

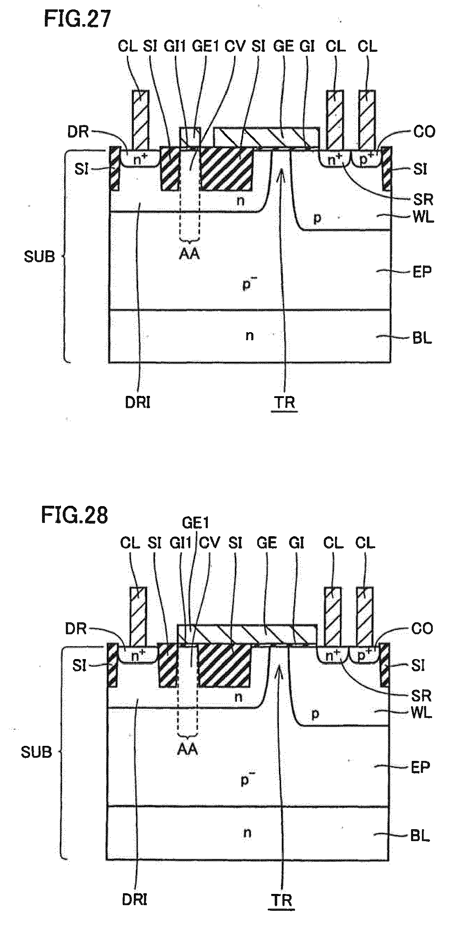

Referring to Figs. 27 and 28, a configuration according to the present embodiment is different from the configuration according to the first embodiment shown in Fig. 2 in that an additional conductive layer GE1 is formed on the surface (main surface) of substrate protruding portion CV (active region AA) between recessed portion CP1 and recessed portion CP2, with an insulation film GI1 interposed therebetween. This additional conductive layer GE1 is electrically insulated from substrate protruding portion CV (active region AA) by insulation film GI1.

As shown in Fig. 27, additional conductive layer GE1 may be electrically insulated from gate electrode layer GE by isolating additional conductive layer GE1 from gate electrode layer GE. A potential of additional conductive layer GE1 shown in Fig. 27 may be any one of the floating potential, the GND, a drain potential, and a gate potential.

As shown in Fig. 28, additional conductive layer GE1 may be electrically connected to gate electrode layer GE to have the same potential (gate potential), by integrating additional conductive layer GE1 with gate electrode layer GE.

The configuration other than described above, of the configuration according to the present embodiment shown in each of Figs. 27 and 28, is substantially the same as the configuration according to the first embodiment, and thus, the same reference characters are assigned to the same components and description thereof will not be repeated.

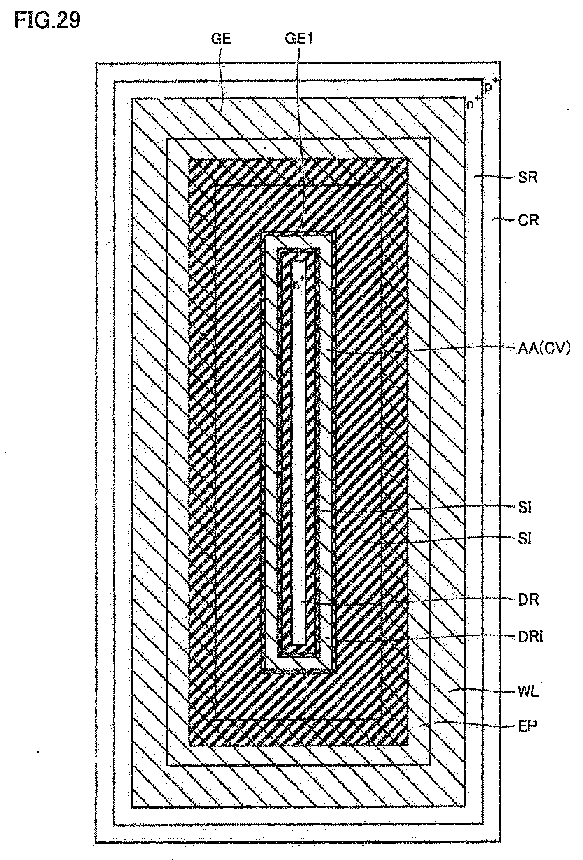

Next, a modification of a planar structure of the present embodiment in a planar view will be described with reference to Figs. 29 to 33.

Referring to Fig. 29, this planar structure has such a configuration that additional conductive layer GE1 isolated from gate electrode layer GE is added to the planar structure shown in Fig. 1. This additional conductive layer GE1 is formed on the whole of substrate protruding portion CV (active region AA) in a planar view. Additional conductive layer GE1 surrounds the entire perimeter of n⁺ drain region DR in a planar view and has, for example, a rectangular frame shape.

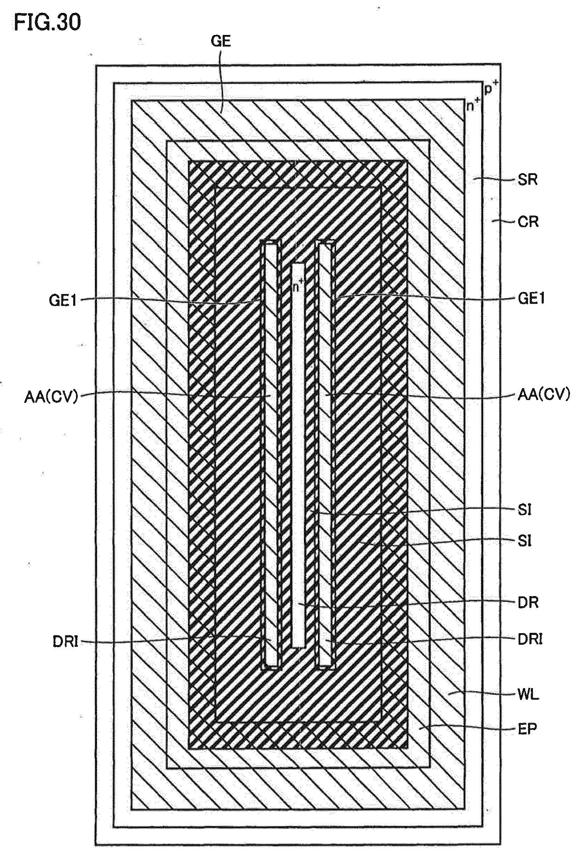

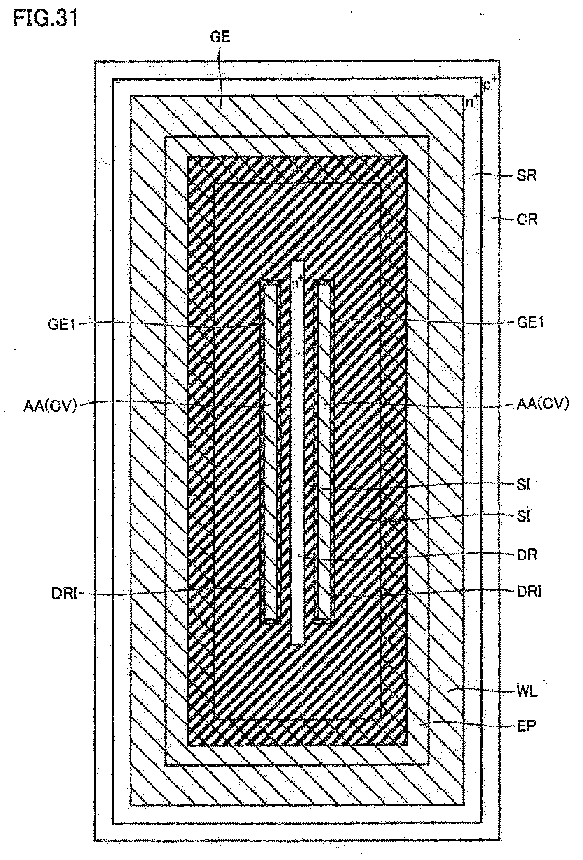

Referring to Figs. 30 and 31, these planar structures have such a configuration that additional conductive layer GE1 isolated from gate electrode layer GE is added to the planar structures shown in Figs. 9 and 10. This additional conductive layer GE1 is formed on the whole of substrate protruding portion CV (active region AA) in a planar view. Additional conductive layer GE1 has a straight line shape extending to run in the same direction (vertical direction in the figure) as the longitudinal direction of n⁺ drain region DR in a planar view. In a planar view, a length in the longitudinal direction (vertical direction in the figure) of additional conductive layer GE1 having the straight line shape may be longer than a length in the longitudinal direction of n⁺ drain region DR as shown in Fig. 30, or may be shorter than a length in the longitudinal direction of n⁺ drain region DR as shown in Fig. 31.

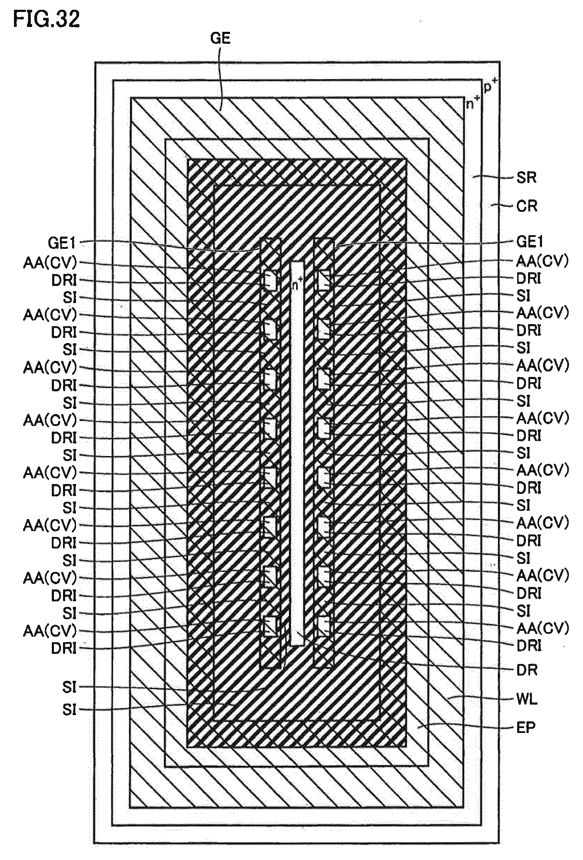

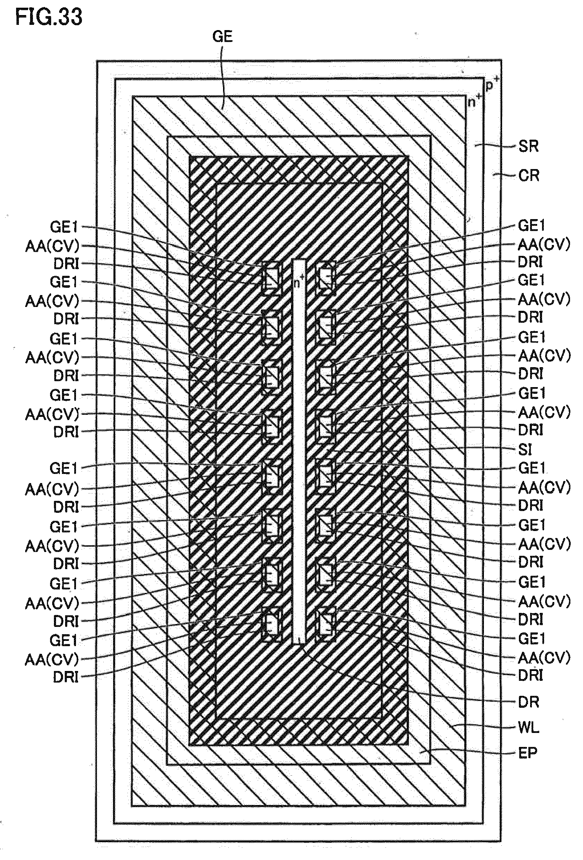

Referring to Figs. 32 and 33, these planar structures have such a configuration that additional conductive layer GE1 isolated from gate electrode layer GE is added to the planar structure shown in Fig. 11. This additional conductive layer GE1 is formed on the whole of substrate protruding portion CV (active region AA) in a planar view. As shown in Fig. 32, one additional conductive layer GE1 may be arranged over a plurality of substrate protruding portions CV (active regions AA) arranged in the longitudinal direction (vertical direction in the figure) in a planar view. Alternatively, as shown in Fig. 33, each of a plurality of additional conductive layers GE1 may be individually arranged on each of a plurality of substrate protruding portions CV (active regions AA) arranged in the longitudinal direction (vertical direction in the figure) in a planar view.

In the configuration shown in Fig. 27, when the potential of additional conductive layer GE1 is the GND, the OFF breakdown voltage is improved, and when the potential of additional conductive layer GE1 is the drain voltage, the ON resistance and the ON breakdown voltage are improved. In the configurations shown in Figs. 27 and 28, when the potential of additional conductive layer GE1 is the gate potential, the ON resistance is improved.

### (Fourth Embodiment)

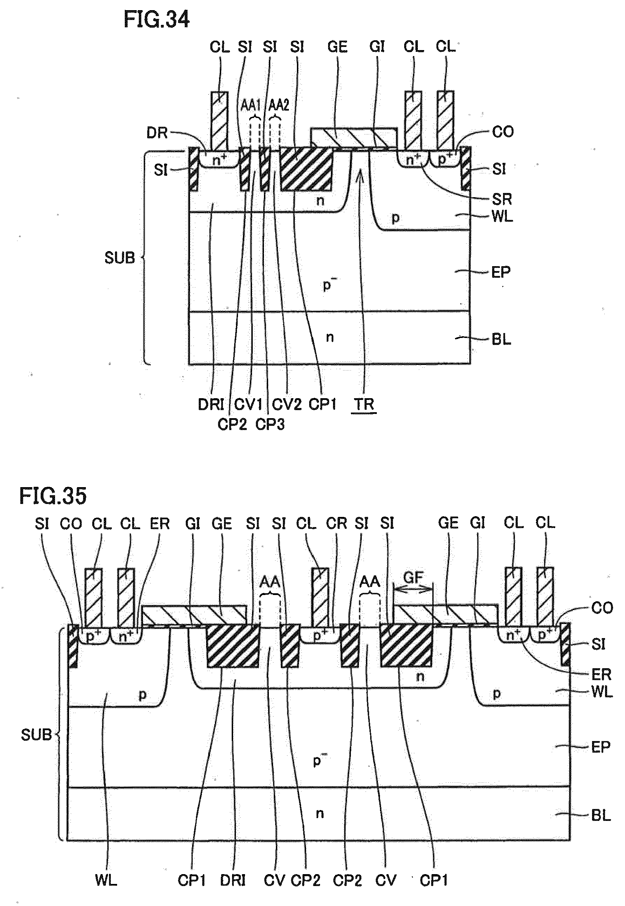

Referring to Fig. 34, a configuration according to the present embodiment is different from the configuration according to the first embodiment shown in Fig. 2 in that a plurality of substrate protruding portions CV1 and CV2 (active regions AA1 and AA2) are formed between recessed portion CP1 and recessed portion CP2. The plurality of substrate protruding portions CV1 and CV2 (active regions AA1 and AA2) are, for example, two substrate protruding portions CV1 and CV2 (active regions AA1 and AA2). Two substrate protruding portions CV1 and CV2 (active regions AA1 and AA2) are isolated from each other by a recessed portion CP3. Similarly to recessed portions CP1 and CP2, element isolation insulation film SI fills in recessed portion CP3. The plurality of substrate protruding portions CV1 and CV2 (active regions AA1 and AA2) are not limited to two and may be three or more.

The configuration other than described above, of the configuration according to the present embodiment shown in Fig. 34, is substantially the same as the configuration according to the first embodiment, and thus, the same reference characters are assigned to the same components and description thereof will not be repeated.

It can be expected that the effect similar to that of the first embodiment is also produced from the configuration in which the plurality of substrate protruding portions CV1 and CV2 (active regions AA1 and AA2) are formed between recessed portion CP1 and recessed portion CP2 as in the present embodiment.

### (First Modification)

The LDMOS transistor has been described in the aforementioned first to fourth embodiments. However, as shown in Fig. 35, the configuration in which substrate protruding portion CV, CV1, CV2 (active region AA, AA1, AA2) is formed between recessed portion CP1 and recessed portion CP2 is also applicable to an IGBT (Insulated Gate Bipolar Transistor). Referring to Fig. 35, this IGBT is different from the LDMOS transistor shown in Fig. 2 in that a p⁺ collector region CR is formed instead of n⁺ drain region DR of the transistor, and in that n⁺ source region SR of the LDMOS transistor functions as an n⁺ emitter region ER.

The configuration other than described above, of the configuration of the IGBT shown in Fig. 35, is substantially the same as the configuration of the LDMOS transistor shown in Fig. 2, and thus, the same reference characters are assigned to the same components and description thereof will not be repeated.

### (Second Modification)

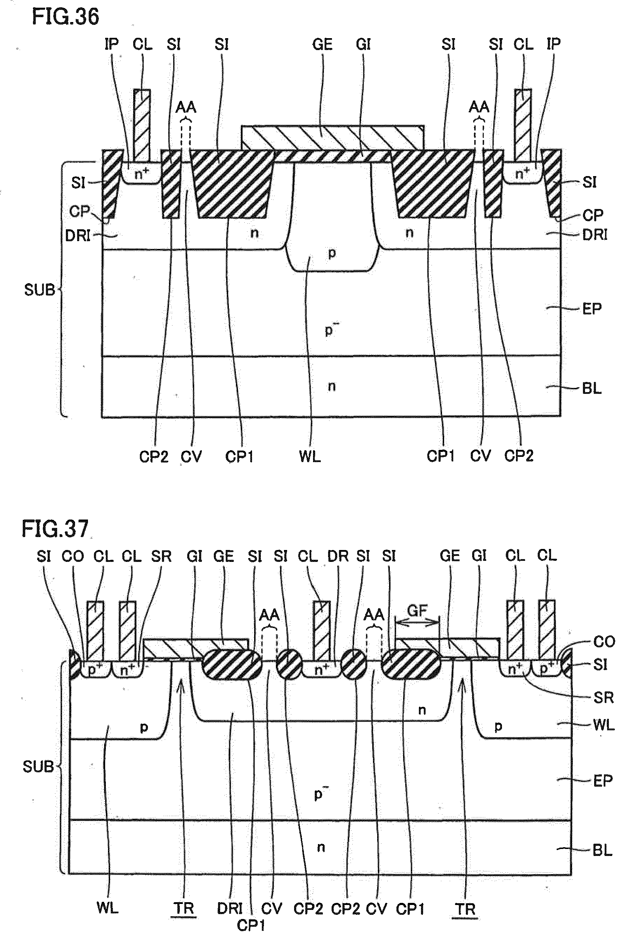

The LDMOS transistor has been described in the aforementioned first to fourth embodiments. However, as shown in Fig. 36, the configuration in which substrate protruding portion CV, CV1, CV2 (active region AA, AA1, AA2) is formed between recessed portion CP1 and recessed portion CP2 is also applicable to a lateral bidirectional transistor. Referring to Fig. 36, this lateral bidirectional transistor mainly has a pair of n-type well regions DRI formed in the main surface of semiconductor substrate SUB, p-type well region WL formed between this pair of n-type well regions DRI, impurity regions IP for a pair of source/drain regions, gate insulation film GI, and gate electrode layer GE.

N-type buried layer BL is formed inside semiconductor substrate SUB. Inside semiconductor substrate SUB and on the main surface side of n-type buried layer BL, p⁻ epitaxial region EP is formed to make a pn junction with the n-type buried layer.

Inside semiconductor substrate SUB and on the main surface side of p⁻ epitaxial region EP, the pair of n-type well regions DRI and p-type well region WL are formed. This n-type well region DRI makes a pn junction with a p⁻ epitaxial region EP2, which extends in the direction along the main surface. P-type well region WL is formed to be located between the pair of n-type well regions DRI and to be in contact with p⁻ epitaxial region EP. P-type well region WL has a p-type impurity concentration higher than that of p⁻ epitaxial region EP.

The element isolation structure having, for example, the STI structure is formed in the main surface of semiconductor substrate SUB. This element isolation structure having the STI structure has recessed portions CP1, CP2 and CP, and element isolation insulation film SI. Each of recessed portions CP1, CP2 and CP is formed in the main surface of semiconductor substrate SUB. Element isolation insulation film SI is formed to fill in each of recessed portions CP1, CP2 and CP.

Recessed portion CP1 (first recessed portion), recessed portion CP2 (second recessed portion) and recessed portion CP are formed in the main surface inside n-type well region DRI, and are formed to be shallower than n-type well region DRI.

Each of impurity regions IP for the pair of source/drain regions is formed in the main surface of semiconductor substrate SUB sandwiched between recessed portion CP2 and recessed portion CP, and has an n-type impurity concentration higher than that of n-type drift region DRI.

Gate electrode layer GE is formed on p-type well region WL sandwiched between the pair of n-type well regions DRI, with gate insulation film GI interposed therebetween. A part of this gate electrode layer GE extends over element isolation insulation film SI for filling in recessed portion CP1. Conductive layer CL serving as an electrode is formed on the main surface of semiconductor substrate SUB so as to be electrically connected to each of impurity regions IP for the pair of source/drain regions.

In the aforementioned configuration, substrate protruding portion CV is arranged between recessed portion CP1 and recessed portion CP2 in the main surface of semiconductor substrate SUB. Element isolation insulation film SI is not formed on this substrate protruding portion CV and the main surface of substrate protruding portion CV serves as active region AA. Namely, recessed portion CP1 and recessed portion CP2 are isolated from each other in the main surface by active region AA. In the present embodiment, n-type well region DRI is formed in the main surface of this active region AA. In addition, in the present embodiment, gate electrode layer GE does not extend onto active region AA.

The aforementioned lateral bidirectional transistor can also produce the function and effect similar to those of the first to fourth embodiments.

### (Third Modification)

In the foregoing, the STI structure has been described as the element isolation structure. However, as shown in Fig. 37, element isolation insulation film SI may be formed of a silicon oxide film formed by using a LOCOS (LOCal Oxidation of Silicon) method.

The configuration other than described above, of the configuration shown in Fig. 37, is substantially the same as the configuration shown in Fig. 2, and thus, the same reference characters are assigned to the same components and description thereof will not be repeated.

Even when the silicon oxide film formed by using the LOCOS method is used as the element isolation structure, the function and effect similar to those of the first to fourth embodiments can be obtained.

### (Fourth Modification)

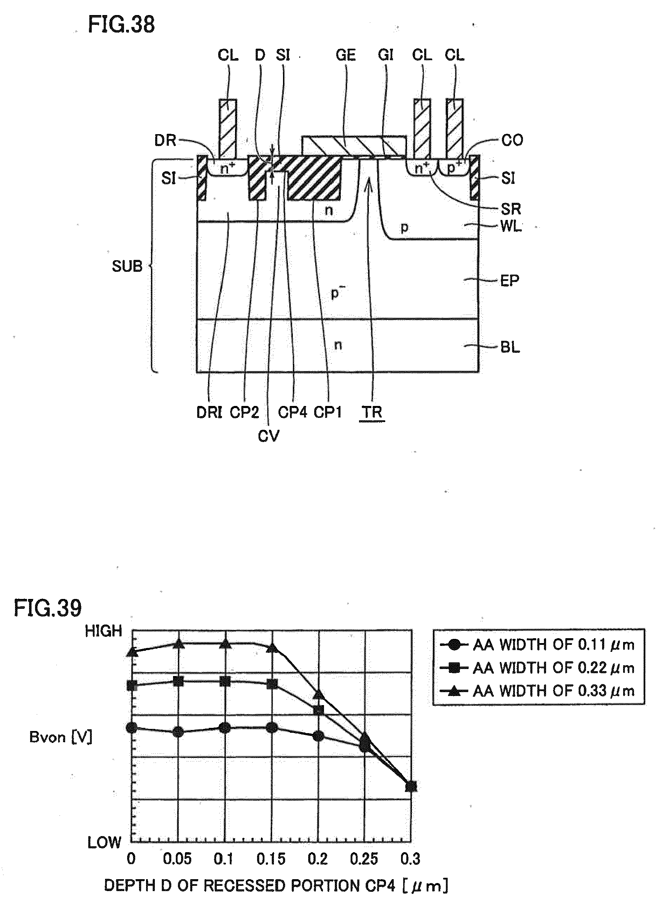

In the foregoing, such a configuration has been described that element isolation insulation film SI is not formed on substrate protruding portion CV and substrate protruding portion CV serves as active region AA. However, as shown in Fig. 38, element isolation insulation film SI may be formed on substrate protruding portion CV. Specifically, a recessed portion CP4 formed on substrate protruding portion CV is formed to be shallower than recessed portions CP1 and CP2, and thereby, substrate protruding portion CV is formed between recessed portion CP1 and recessed portion CP2.

The configuration other than described above, of the configuration shown in Fig. 38, is substantially the same as the configuration shown in Fig. 2, and thus, the same reference characters are assigned to the same components and description thereof will not be repeated.

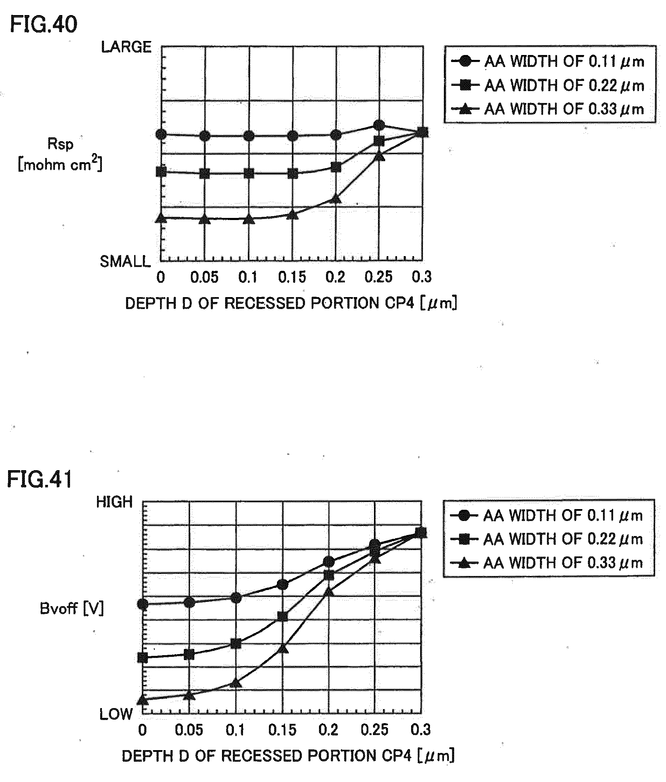

Next, results of study on the ON breakdown voltage (Bvon), the ON resistance (Rsp) and the OFF breakdown voltage (Bvoff) when a depth D of recessed portion CP4 is changed in the configuration according to the present modification shown in Fig. 38 will be described with reference to Figs. 39 to 41.

The simulation shown in Figs. 39 to 41 was performed under the conditions that each of the STI width in the present embodiment (Fig. 2) and the STI width in the comparative example (Fig. 3) was 1.7 µm, gate overlap amount GF was 0.7 µm, and a depth of each of recessed portions CP1 and CP2 was 0.3 µm. Therefore, the state in which depth D of recessed portion CP4 in each of Figs. 39 to 41 is 0.3 µm refers to the state shown in Fig. 3 (comparative example), and the state in which depth D of recessed portion CP4 is 0 µm refers to the state shown in Fig. 2 (first embodiment).

Referring to Figs. 39 to 41, it was found that even when recessed portion CP4 is formed on substrate protruding portion CV and element isolation insulation film SI fills in this recessed portion CP4, the ON breakdown voltage can be improved and the ON resistance can be reduced as compared with the comparative example (depth D is 0.3 µm), similarly to the configuration in which recessed portion CP4 is not formed on substrate protruding portion CV as shown in Fig. 2 (depth D is 0 µm). It was also found that when depth D of recessed portion CP4 is equal to or smaller than 0.15 µm, the ON breakdown voltage and the ON resistance that are substantially the same as those of the configuration shown in Fig. 2 (depth D is 0 µm) are obtained.

Therefore, also in the configuration in which element isolation insulation film SI is formed on substrate protruding portion CV as shown in Fig. 38, the ON breakdown voltage can be improved and the ON resistance can be reduced as compared with the comparative example (depth D is 0.3 µm), similarly to the configuration shown in Fig. 2 (depth D is 0 µm).

### (Others)

In the aforementioned embodiments and modifications, the IGBT having the n-type LDMOS transistor, the n-type bidirectional transistor and the n⁺ emitter region has been described. However, the configurations according to the aforementioned embodiments are similarly applicable to an IGBT having a p-type LDMOS transistor, a p-type bidirectional transistor and a p⁺ emitter region.

The aforementioned embodiments and modifications can be combined as appropriate.

While the invention made by the present inventors has been specifically described above based on the embodiments, the present invention is by no means limited to the foregoing embodiments, and can be modified in various manners without departing from the gist of the invention.

### REFERENCE SIGNS LIST

AA, AA1 active region; AR p-type impurity region; BL n-type buried layer; CL conductive layer; CO contact region; CP, CP1 to CP4 recessed portion; CR p⁺ collector region; CV, CV1 substrate protruding portion; DR n⁺ drain region; DRI n-type drift region (n-type well region); EP, EP2 p⁻ epitaxial region; ER n⁺ emitter region; GE gate electrode layer; GE1 additional conductive layer; GI gate insulation film; GI1 insulation film; IP impurity region; SI element isolation insulation film; SR n⁺ source region; SUB semiconductor substrate; TR transistor; WL p-type well region.

## Claims

1. A semiconductor device, comprising:
a semiconductor substrate having a main surface and having a first recessed portion and a second recessed portion in said main surface;
an element isolation insulation film formed inside each of said first recessed portion and said second recessed portion;
a pair of impurity regions formed to sandwich said first recessed portion and said second recessed portion in said main surface and serving as any one of a pair of source/drain regions and a pair of emitter/collector regions,
one region of said pair of impurity regions having a first conductivity type;
a first region of a second conductivity type formed in said main surface between said one region and said first recessed portion and serving as a channel formation region; and
a gate electrode layer formed on said first region with a gate insulation film interposed therebetween, and extending at least onto said element isolation insulation film in said first recessed portion,
said first recessed portion and said second recessed portion being arranged to be adjacent to each other to sandwich a substrate protruding portion protruding toward said main surface side with respect to a bottom portion of each of said first recessed portion and said second recessed portion.

2. The semiconductor device according to claim 1, wherein
said substrate protruding portion is an active region sandwiched between said first recessed portion and said second recessed portion, and
said main surface of said active region has a first conductivity type impurity concentration lower than a first conductivity type impurity concentration of said main surface of said one region.

3. The semiconductor device according to claim 1, wherein
said substrate protruding portion is an active region sandwiched between said first recessed portion and said second recessed portion,
the semiconductor device further comprising
a second region of a second conductivity type formed in said main surface of said active region.

4. The semiconductor device according to claim 3, wherein
said second region is formed to be shallower than said first recessed portion and said second recessed portion.

5. The semiconductor device according to claim 3, wherein
said second region is formed to be deeper than said first recessed portion and said second recessed portion.

6. The semiconductor device according to claim 1, wherein
said substrate protruding portion is an active region sandwiched between said first recessed portion and said second recessed portion,
the semiconductor device further comprising:
a second region of a second conductivity type formed in said main surface of said active region; and
a third region of a first conductivity type formed in said main surface of said active region and being adjacent to said second region.

7. The semiconductor device according to claim 1, wherein
said substrate protruding portion is an active region sandwiched between said first recessed portion and said second recessed portion,
the semiconductor device further comprising
a conductive layer formed on said active region with an insulation film interposed therebetween.

8. The semiconductor device according to claim 7, wherein
said conductive layer is formed to be isolated from said gate electrode layer.

9. The semiconductor device according to claim 7, wherein
said conductive layer is formed to be integrated with said gate electrode layer.
